# EUROPÄISCHE PATENTSCHRIFT

(11) **EP 1 913 445 B1**
(45) Veröffentlichungstag und Bekanntmachung des Hinweises auf die Patenterteilung: **25.05.2011**
(21) Anmeldenummer: 06778169.0
(22) Anmeldetag: 04.08.2006
(51) Int. Cl.: G03F 7/20, G02B 1/00

(54) **ABBILDUNGSSYSTEM, INSBESONDERE PROJEKTIONSOBJEKTIV EINER MIKROLITHOGRAPHISCHEN PROJEKTIONSBELICHTUNGSANLAGE**
IMAGING SYSTEM, IN PARTICULAR PROJECTION LENS OF A MICROLITHOGRAPHIC PROJECTION EXPOSURE UNIT
SYSTEME DE REPRODUCTION, EN PARTICULIER OBJECTIF DE PROJECTION D'UNE INSTALLATION D'EXPOSITION PAR PROJECTION MICROLITHOGRAPHIQUE

(30) Priorität: 10.08.2005 US 706903 P
(43) Veröffentlichungstag der Anmeldung: 23.04.2008
(73) Patentinhaber: Carl Zeiss SMT GmbH, 73447 Oberkochen (DE)
(72) Erfinder: SCHUSTER, Karl-Heinz, 89551 Königsbronn (DE)
(74) Vertreter: Frank, Hartmut
(86) Internationale Anmeldenummer: PCT/EP2006/065070
(87) Internationale Veröffentlichungsnummer: WO 2007/017473

(56) Entgegenhaltungen:
- WO-A-2005/006417
- WO-A2-2005/059617
- US-A1- 2003 027 349
- US-A1- 2005 030 506
- US-A1- 2005 117 224
- SCHOLZE H.: "Glas - Natur, Struktur und Eigenschaften" 1988, SPRINGER-VERLAG BERLIN HEIDELBERG , BERLIN HEIDELBERG GERMANY , XP002406885 dritte Auflage, Kapitel 2.6.1, Seite 121 - 140

## Beschreibung

### HINTERGRUND DER ERFINDUNG

### Gebiet der Erfindung

Die Erfindung betrifft ein Abbildungssystem, insbesondere ein Projektionsobjektiv einer mikrolithographischen Projektionsbelichtungsanlage. Insbesondere betrifft die Erfindung ein Projektionsobjektiv, welches den Einsatz hochbrechender Kristallmaterialien bei Begrenzung des negativen Einflusses der intrinsischen Doppelbrechung auf die Abbildungseigenschaften ermöglicht.

### Stand der Technik

In gegenwärtigen Mikrolithographie-Objektiven, insbesondere Immersionsobjektiven mit einem Wert der numerischen Apertur (NA) von mehr als 1.0, besteht in zunehmendem Maße ein Bedarf nach dem Einsatz von Materialien mit hohem Brechungsindex. Als "hoch" wird hier ein Brechungsindex bezeichnet, wenn sein Wert bei der gegebenen Wellenlänge den von Quarz, mit einem Wert von ca. 1,56 bei einer Wellenlänge von 193nm, übersteigt. Es sind eine Reihe von Materialien bekannt, deren Brechungsindex bei DUV- und VUV-Wellenlängen (<250nm) größer als 1,6 ist, beispielsweise Magnesiumspinell mit einem Brechungsindex von ca. 1.87 bei einer Wellenlänge von 193nm, oder Magnesiumoxid, dessen Brechungsindex bei 193nm etwa 2.0 beträgt.

Ein Problem beim Einsatz dieser Materialien als Linsenelemente besteht darin, dass sie durch ihre kubische Kristallstruktur intrinsische Doppelbrechung aufweisen, die mit niedriger Wellenlänge ansteigt, wobei z.B. Messungen der IDB-bedingten Verzögerung für Magnesiumspinell bei einer Wellenlänge von 193nm einen Wert von 52 nm/cm ergeben haben, und die IDBbedingte Verzögerung für Magnesiumoxid bei 193nm zu etwa 72 nm/cm abgeschätzt wurde. Eine solche Verzögerung kann je nach Designbedingungen im Bildfeld zu lateralen Strahlabweichungen führen, die das 3- bis 5-fache der abzubildenden Strukturbreite betragen.

Zur Reduzierung des negativen Einflusses der intrinsischen Doppelbrechung in Fluoridkristall-Linsen auf die optische Abbildung ist es beispielsweise aus US 2004/0105170 A1 und WO 02/093209 A2 u.a. bekannt, Fluoridkristall-Linsen des gleichen Kristallschnitts gegeneinander verdreht anzuordnen (sogenanntes "Clocking"), sowie zusätzlich auch mehrere Gruppen solcher Anordnungen mit unterschiedlichen Kristallschnitten (z.B. aus 100-Linsen und 111-Linsen) miteinander zu kombinieren.

Wenngleich durch dieses Verfahren eine gewisse Kompensation des negativen Einflusses der intrinsischen Doppelbrechung auch in den o.g. hochbrechenden kubischen Materialien erreichbar ist, besteht ein weiteres Problem darin, dass die Kompensation durch das o.g. "Clocking" dann unvollkommen ist, wenn die jeweiligen "Kompensationswege" (z.B. die jeweiligen Strahlwege der zur Interferenz gelangenden Strahlen in den zueinander verdrehten Bereichen des gleichen Kristallschnitts) unterschiedlich sind, wie es insbesondere bei außeraxialen Strahlbüscheln beispielsweise in einer bildseitig letzten plankonvexen Linse (als typischer Einsatzort des hochbrechenden Materials) der Fall ist. Dieser Umstand wirkt sich umso stärker aus, je stärker der Effekt der intrinsischen Doppelbrechung ist, was gerade einen Einsatz der o.g. hochbrechenden Materialien im bildnahen Bereich von Lithographie-Objektiven, z.B. als letztes Linsenelement, unter den dort auftretenden großen Strahlwinkeln, bei denen auch die intrinsische Doppelbrechung im (100)- und (111)- Kristallschnitt besonders hoch ist, erschwert.

Aus WO 2005/059617 A2 ist u.a. ein Projektionsobjektiv mit einem bildseitig letzten optischen Element aus einem Material mit hohem Brechungsindex (n ≥ 1.6), insbesondere Saphir, sowie typischen numerischen Aperturen größer als 1.35 bekannt.

### ZUSAMMENFASSUNG DER ERFINDUNG

Aufgabe der vorliegenden Erfindung ist es, ein Abbildungssystem, insbesondere ein Projektionsobjektiv einer mikrolithographischen Projektionsbelichtungsanlage bereitzustellen, welches den Einsatz hochbrechender Kristallmaterialien bei Begrenzung des negativen Einflusses intrinsischer Doppelbrechung ermöglicht.

Gemäß einem Aspekt der Erfindung umfasst ein erfindungsgemäßes Abbildungssystem, insbesondere ein Projektionsobjektiv einer mikrolithographischen Projektionsbelichtungsanlage, wenigstens ein optisches Element, welches ein kubisches Kristallmaterial aufweist, das bei einer vorgegebenen Arbeitswellenlänge eine Brechzahl n größer als 1.6 hat, und besitzt eine bildseitige numerische Apertur NA, welche kleiner als die Brechzahl n ist, wobei die Differenz (n-NA) zwischen der Brechzahl n und der numerischen Apertur NA des Abbildungssystems maximal 0.2 beträgt.

Die Erfindung geht dabei zunächst von der Erkenntnis aus, dass der Effekt der intrinsischen Doppelbrechung mit kürzer werdender Wellenlänge nicht linear ansteigt, sondern vielmehr zunächst allmählich einsetzt und dann mit fallender Wellenlänge dramatisch ansteigt. Diese Nichtlinearität ist umso stärker ausgeprägt, je mehr sich die jeweilige Arbeitswellenlänge der Absorptionskante (im UV-Bereich) für das betreffende Material nähert.

Erfindungsgemäß wird nun das Potential an Materialien mit möglichst hohen Brechzahlen nicht ausgeschöpft, sondern die Brechzahl wird gerade so hoch (und nicht höher) gewählt, wie es erforderlich ist, um geometrisch Projektionslicht auch unter den maximal auftretenden Strahlwinkeln noch durch das Projektionsobjektiv zu koppeln und zur Abbildung zu bringen. Zugleich wird erfindungsgemäß die moderatere Anforderung an die Höhe der Brechzahl ausgenutzt, um ein solches Kristallmaterial auszuwählen, dessen Absorptionskante tiefer im UV liegt, so dass infolgedessen die intrinsische Doppelbrechung im Bereich der Arbeitswellenlänge noch kleiner bzw. weniger stark angestiegen ist, als dies bei einem Material mit höher liegender Absorptionskante der Fall ist.

Bei einer numerischen Apertur von beispielsweise NA= 1.5 wird erfindungsgemäß, trotz gegebener Verfügbarkeit von bei typischen Arbeitswellenlängen von 193nm transparenten Materialien mit hohen Brechzahlen von beispielsweise n=1.87 (Magnesiumspinell) und darüber, bewusst auf die Wahl möglichst hochbrechender Kristallmaterialien verzichtet, sondern es wurden erfindungsgemäß vielmehr Materialien gesucht und gefunden, bei denen der Abstand der Brechzahl n zur (tieferliegenden) bildseitigen numerischen Apertur des Abbildungssystems geringer ist, aber gerade noch ausreicht, um das Projektionslicht auch unter maximal auftretenden Strahlwinkeln noch durch das Abbildungssystem zu koppeln bzw. zur Abbildung zu bringen.

Gemäß einem weiteren Aspekt umfasst ein Abbildungssystem, insbesondere ein Projektionsobjektiv einer mikrolithographischen Projektionsbelichtungsanlage, wenigstens ein optisches Element, welches ein kubisches Kristallmaterial aufweist, das bei einer vorgegebenen Arbeitswellenlänge eine Brechzahl n hat, und besitzt eine bildseitige numerische Apertur NA, welche kleiner als die Brechzahl n ist, von wenigstens 1.50, wobei die Differenz (n-NA) zwischen der Brechzahl n und der numerischen Apertur NA des Abbildungssystems maximal 0.2 beträgt.

Vorzugsweise liegt die Differenz (n-NA) zwischen der Brechzahl n des optischen Elements und der numerischen Apertur NA des Abbildungssystems im Bereich von 0.05 bis 0.20, vorzugsweise im Bereich von 0.05 bis 0.15, und besonders bevorzugt im Bereich von 0.05 bis 0.10. Dabei wird durch die obere Grenze der Brechzahl wie oben ausgeführt eine Begrenzung der intrinsischen Doppelbrechung erreicht, während durch die untere Grenze der Brechzahl eine Begrenzung des Gesamtlinsenvolumens des Projektionsobjektivs erreicht wird.

Weitere, durch die erfindungsgemäß zum Einsatz kommenden Materialien vorzugsweise zu erfüllende Kriterien sind eine hinreichende Stabilität gegenüber Luftfeuchtigkeit und UV-Licht, hohe Härte und gute optische Bearbeitbarkeit, sowie möglichst ungiftige Bestandteile.

In einer bevorzugen Ausführung weist das kubische Kristallmaterial ein Oxid auf, wofür eine ausreichende Transmission bei vergleichsweise hoher Brechzahl erhalten wurde.

In einer bevorzugen Ausführung weist das kubische Kristallmaterial Saphir (Al₂O₃) und ein Kalium- oder Kalziumoxid auf.

Insbesondere weist das kubische Kristallmaterial vorzugsweise wenigstens ein Material auf, welches aus der Gruppe ausgewählt ist, die 7Al₂O₃·12CaO, Al₂O₃·K₂O, Al₂O_{3·}3CaO, Al₂O₃·SiO₂KO, Al₂O₃-SiO₂·2K und Al₂O₃·3CaO6H₂O enthält.

Dabei bewirkt der Anteil von Saphir (Al₂O₃) eine Verbreiterung der Bandlücke bzw. eine Verschiebung der Absorptionskante in den UV-Bereich bei gleichzeitiger Erhöhung der Brechzahl, so dass brechzahlsenkende weitere Bestandteile den Mischkristall ergänzen, was zu der obigen Verringerung der intrinsischen Doppelbrechung führt.

In einer weiteren bevorzugen Ausführung weist das kubische Kristallmaterial Kalzium, Natrium und Siliziumoxid auf. Insbesondere weist das kubische Kristallmaterial vorzugsweise wenigstens ein Material aus der Gruppe auf, die CaNa₂SiO₄ und CaNa₄Si₃O₉ enthält.

In einer weiteren bevorzugen Ausführung weist das kubische Kristallmaterial wenigstens ein Material aus der Gruppe auf, die Sr(NO₃)_{2,} MgONa₂O_{·}SiO₂ und Ca(NO₃)₂ enthält.

Das optische Element ist vorzugsweise die bildseitig letzte brechende Linse des Abbildungssystems.

Gemäß einer bevorzugten Ausführungsform ist das optische Element aus einem ersten Teilelement mit Brechkraft und einem zweiten, im Wesentlichen brechkraftlosen Teilelement zusammengesetzt. Vorzugsweise ist dabei das das erste Teilelement eine im Wesentlichen plankonvexe Linse, und das zweite Teilelement ist eine planparallele Platte.

Ein solcher Aufbau des optischen Elements hat den Vorteil einer besonders effektiven Korrektur der sphärischen Aberration, welche typischerweise bei hohen Aperturen den größten zu bewältigenden Beitrag an Abbildungsfehlern darstellt. Bei telezentrischem Strahlengang im Bereich des optischen Elementes kann insbesondere durch das planparallele Teilelement in vorteilhafter Weise eine über das Bildfeld gleichmäßige Korrektur der sphärischen Aberration erreicht werden.

Im Gegensatz zu dem ersten Teilelement mit Brechkraft (d.h. insbesondere der plankonvexen Linse) treten in dem zweiten, in Wesentlichen brechkraftlosen Teilelement bei einem Aufbau aus gegeneinander verdrehten Teilbereichen des gleichen Kristallschnitts für die jeweiligen Teilbereiche jeweils im Wesentlichen gleiche Kompensationswege auf, so dass insoweit eine effektive Korrektur der intrinsischen Doppelbrechung im Wege des "Clocking-Schemas" erfolgen kann. Folglich ist es vorteilhaft, in dem zweiten, im Wesentlichen brechkraftlosen Teilelement ein zweites Material mit größerer Brechzahl als das Material in dem ersten Bereich vorzusehen, wobei diese größere Brechzahl insbesondere auch jenseits des o.g. Abstands von der numerischen Apertur liegen kann.

In einer bevorzugten Ausführungsform ist daher das zweite Material aus der Gruppe Magnesiumspinell (MgAl₂O₄), Yttriumaluminiumgranat (Y₃Al₅O₁₂), MgO und Scandiumaluminiumgranat (Sc₃Al₅O₁₂) ausgewählt.

Zur Kompensation der intrinsischen Doppelbrechung weist (zur Realisierung des Clocking-Schemas) das zweite Teilelement eine Elementachse und wenigstens zwei Teilbereiche auf, welche den gleichen Kristallschnitts aufweisen und gegeneinander um die Elementachse verdreht angeordnet sind.

In einer Ausführung weisen der erste Teilbereich und der zweite Teilbereich jeweils einen (111)-Kristallschnitt auf und sind gegeneinander um 60°+k*120° (k=0, 1, 2,...) um die Elementachse verdreht angeordnet.

In einer weiteren Ausführung weisen der erste Teilbereich und der zweite Teilbereich jeweils einen (100)-Kristallschnitt auf und sind gegeneinander um 45°+1*90° (1=0,1,2,...) um die Elementachse verdreht angeordnet.

In einer weiteren Ausführung weist das zweite Teilelement eine Elementachse und wenigstens vier Teilbereiche auf, wobei ein erster Teilbereich und ein zweiter Teilbereich jeweils einen (111)-Kristallschnitt aufweisen und gegeneinander um 60°+k*120° (k=0,1,2,...) um die Elementachse verdreht angeordnet sind, und wobei ein dritter Teilbereich und ein vierter Teilbereich jeweils einen (100)-Kristallschnitt aufweisen und gegeneinander um 45°+1*90° (1=0,1,2,...) um die Elementachse verdreht angeordnet sind.

Die Erfindung betrifft ferner eine mikrolithographische Projektionsbelichtungsanlage sowie ein Verfahren zur Herstellung mikrolithographischer Bauelemente.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

### KURZE BESCHREIBUNG DER ZEICHNUNGEN

Es zeigen:
- Figur 1: eine schematische Darstellung zur Erläuterung des Aufbaus eines optischen Elements in einem erfin- dungsgemäßen Abbildungssystem in einer bevorzugten Ausführungsform; und
- Figur 2: eine schematische Darstellung des prinzipiellen Aufbaus einer Mikrolithographie- Projektionsbelichtungsanlage, welche ein erfin- dungsgemäßes Projektionsobjektiv aufweisen kann.

### DETALLIERTE BESCHREIBUNG BEVORZUGTER AUSFÜHRUNGSFORMEN

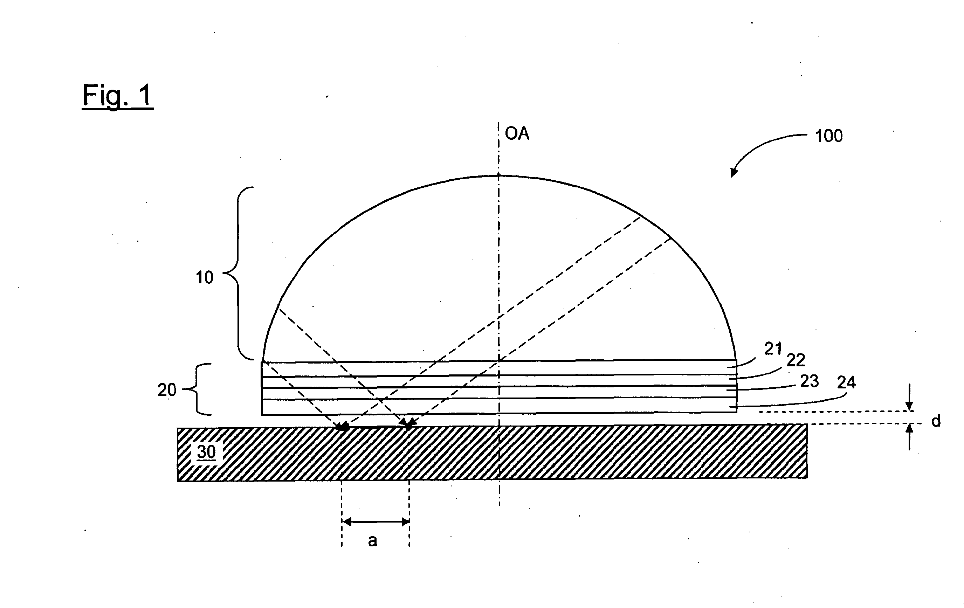

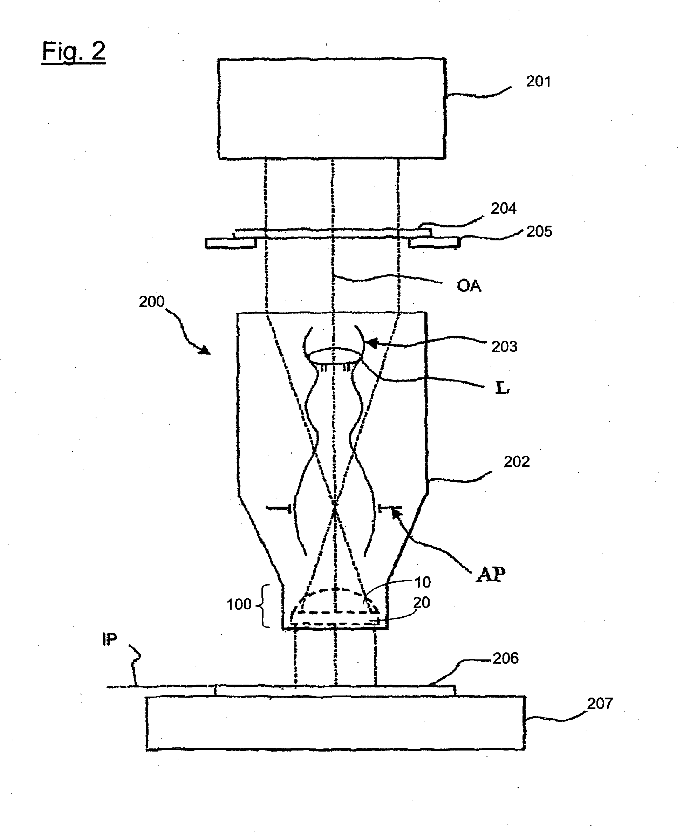

Fig. 1 zeigt lediglich schematisch den Aufbau eines optischen Elements 100 in einem erfindungsgemäßen Abbildungssystem. Das optische Element 100 ist vorzugsweise insbesondere die bildseitig letzte Linse in einem mikrolithographischen Projektionsobjektiv, dessen grundsätzlicher Aufbau noch unter Bezugnahme auf Fig. 2 erläutert wird.

Gemäß Fig. 1 ist das optische Element 100 aus einem ersten Teilelement 10 in Form einer plankonvexen Linse und einem zweiten Teilelement 20 in Form einer planparallelen Platte aufgebaut, wobei die Lichteintrittsfläche des zweiten Teilelements 20 unmittelbar angrenzend an die Lichtaustrittsfläche des ersten Teilelements 10 angeordnet und vorzugsweise auf dieser aufgesprengt ist.

Ebenfalls in Fig. 1 schematisch dargestellt ist der Aufbau des zweiten Teilelements 20 aus insgesamt vier Teilbereichen in Form von planparallelen Teilplatten 21, 22, 23 und 24. Dabei weisen die erste Teilplatte 21 und die zweite Teilplatte 22 jeweils einen (111)-Kristallschnitt auf und sind gegeneinander um 60° (oder allgemein 60°+k*120°, k=0,1,2,...) um die Elementachse (die in Fig. 1 mit der optischen Achse OA übereinstimmt) verdreht angeordnet. Die dritte Teilplatte 23 und die vierte Teilplatte 24 weisen jeweils einen (100)-Kristallschnitt auf und sind gegeneinander um 45° (oder allgemein 45°+1*90°, 1=0,1,2,...) um die Elementachse verdreht angeordnet.

In einer weiteren Ausführung weist das zweite Teilelement 20 insgesamt zwei Teilbereiche auf, welche den gleichen Kristallschnitt aufweisen und gegeneinander um die Elementachse verdreht angeordnet sind. Beispielsweise können diese Teilbereiche jeweils einen (100)-Kristallschnitt aufweisen und gegeneinander um 45°+1*90° (1=0,1,2,...) um die Elementachse verdreht angeordnet sein, oder die Teilbereiche können jeweils einen (111)-Kristallschnitt aufweisen und gegeneinander um 60°+k*120° (k=0, 1, 2,...) um die Elementachse ve.rdreht angeordnet sein.

Das erste Teilelement 10 ist aus einem kubisch kristallinen Material mit einer solchen Brechzahl hergestellt, die in Abhängigkeit von der numerischen Apertur NA des Abbildungssystems so gewählt ist, dass die Differenz (n-NA) zwischen dieser Brechzahl n und der numerischen Apertur NA des Abbildungssystems maximal 0.2 beträgt.

Legt man eine beispielhafte numerische Apertur des Projektionsobjektivs von NA=1.5 zugrunde, so beträgt somit die Brechzahl n des kubisch kristallinen Materials des ersten Teilelements maximal n=1.7.

Eine Auflistung über erfindungsgemäß besonders geeignete Materialien gibt die nachfolgende Tabelle 1. Dabei ist in Spalte 2 jeweils die zu dem Kristallmaterial gehörige Brechzahl n_{d} bei der Wellenlänge λ=589nm angegeben; hierbei ist darauf hinzuweisen, dass die Brechzahl bei einer gebräuchlichen Arbeitswellenlänge von λ=193nm typischerweise um etwa 0.1 größer ist.

**Tabelle 1 :**

| **Material** | **Brechzahl n_{d} (bei λ=589nm)** |
|---|---|
| 7Al₂O₃·12CaO | 1.608 |
| Al₂O₃·K₂O | 1.603 |
| Al₂O₃·3CaO | 1.701 |
| Al₂O₃·SiO₂KO | 1.540 |
| Al₂O₃·SiO₂·2K | |
| Al₂O₃·3CaO6H₂O | 1.604 |
| | |
| CaNa₂SiO₄ | 1.60 |
| CaNa₄Si₃O₉ | 1.571 |
| | |
| Sr (NO₃)₂ | 1.5667 |
| MgONa₂O·SiO₂ | 1.523 |
| Ca (NO₃)₂ | 1.595 |

Gemäß Fig. 2 weist eine Projektionsbelichtungsanlage 200 eine Beleuchtungseinrichtung 201 und ein Projektionsobjektiv 202 auf. Das Projektionsobjektiv 202 umfasst eine Linsenanordnung 203 mit einer Aperturblende AP, wobei durch die lediglich schematisch angedeutete Linsenanordnung 203 eine optische Achse OA definiert wird. Zwischen der Beleuchtungseinrichtung 201 und dem Projektionsobjektiv 202 ist eine Maske 204 angeordnet, die mittels eines Maskenhalters 205 im Strahlengang gehalten wird. Solche in der Mikrolithographie verwendeten Masken 204 weisen eine Struktur im Mikrometer- bis Nanometer-Bereich auf, die mittels des Projektionsobjektives 202 beispielsweise um den Faktor 4 oder 5 verkleinert auf eine Bildebene IP abgebildet wird. In der Bildebene IP wird ein durch einen Substrathalter 207 positioniertes lichtempfindliches Substrat 206, bzw. ein Wafer, gehalten. Die noch auflösbaren minimalen Strukturen hängen von der Wellenlänge λ des für die Beleuchtung verwendeten Lichtes sowie von der bildseitigen numerischen Apertur des Projektionsobjektives 202 ab, wobei die maximal erreichbare Auflösung der Projektionsbelichtungsanlage 200 mit abnehmender Wellenlänge λ der Beleuchtungseinrichtung 201 und mit zunehmender bildseitiger numerischer Apertur des Projektionsobjektivs 202 steigt.

Das Projektionsobjektiv 202 ist als Abbildungssystem gemäß der vorliegenden Erfindung ausgestaltet. In Fig. 2 ist lediglich schematisch eine mögliche, ungefähre Position eines erfindungsgemäßen optischen Elements 100 gestrichelt angedeutet, wobei das optische Element hier gemäß einer bevorzugten Ausführungsform das bildseitig letzte optische Element des Projektionsobjektives 202 und somit im Bereich relativ hoher Aperturwinkel angeordnet ist. Das optische Element weist den anhand von Fig. 1 erläuterten Aufbau auf und ist somit insbesondere aus einem ersten Teilelement 10 in Form einer plankonvexen Linse und einem zweiten Teilelement 20 in Form einer planparallelen Platte gemäß den oben beschriebenen Ausführungsformen aufgebaut.

Wenn die Erfindung auch anhand spezieller Ausführungsformen beschrieben wurde, erschließen sich für den Fachmann zahlreiche Variationen und alternative Ausführungsformen, z.B. durch Kombination und/oder Austausch von Merkmalen einzelner Ausführungsformen. Dementsprechend versteht es sich für den Fachmann, dass derartige Variationen und alternative Ausführungsformen von der vorliegenden Erfindung mit umfasst sind, und die Reichweite der Erfindung nur im Sinne der beigefügten Patentansprüche und deren Äquivalente beschränkt ist.

## Patentansprüche

1. Abbildungssystem, insbesondere Projektionsobjektiv einer mikrolithographischen Projektionsbelichtungsanlage, mit
• wenigstens einem optischen Element (100), welches ein kubisches Kristallmaterial aufweist, das bei einer vorgegebenen Arbeitswellenlänge eine Brechzahl n größer als 1.6 hat;
• und einer bildseitigen numerischen Apertur NA, welche kleiner als die Brechzahl n ist;
• wobei die Differenz (n-NA) zwischen der Brechzahl n und der numerischen Apertur NA des Abbildungssystems maximal 0.2 beträgt.

2. Abbildungssystem, insbesondere Projektionsobjektiv einer mikrolithographischen Projektionsbelichtungsanlage, mit
• wenigstens einem optischen Element (100), welches ein kubisches Kristallmaterial aufweist, das bei einer vorgegebenen Arbeitswellenlänge eine Brechzahl n hat;
• und einer bildseitigen numerischen Apertur NA, welche kleiner als die Brechzahl n ist, von wenigstens 1.50;
• wobei die Differenz (n-NA) zwischen der Brechzahl n und der numerischen Apertur NA des Abbildungssystems maximal 0.2 beträgt.

3. Abbildungssystem nach Anspruch 1 oder 2, **dadurch gekennzeichnet, dass** die Differenz (n-NA) zwischen der Brechzahl n und der numerischen Apertur NA im Bereich von 0.05 bis 0.20 liegt.

4. Abbildungssystem nach einem der vorhergehenden Ansprüche, **dadurch gekennzeichnet, dass** das kubische Kristallmaterial ein Oxid aufweist.

5. Abbildungssystem nach Anspruch 4, **dadurch gekennzeichnet, dass** das kubische Kristallmaterial Saphir (Al₂O₃) und ein Kalium- oder Kalziumoxid aufweist.

6. Abbildungssystem nach einem der vorhergehenden Ansprüche, **dadurch gekennzeichnet, dass** das kubische Kristallmaterial wenigstens ein Material aufweist, welches aus der Gruppe ausgewählt ist, die 7Al₂O₃·12CaO, Al₂O₃·K₂O, Al₂O₃·3CaO, Al₂O₃·SiO₂KO, Al₂O₃·SiO₂·2K und Al₂O₃·3CaO6H₂O enthält.

7. Abbildungssystem nach einem der vorhergehenden Ansprüche, **dadurch gekennzeichnet, dass** das kubische Kristallmaterial Kalzium, Natrium und Siliziumoxid aufweist.

8. Abbildungssystem nach einem der vorhergehenden Ansprüche, **dadurch gekennzeichnet, dass** das kubische Kristallmaterial wenigstens ein Material aufweist, welches aus der Gruppe ausgewählt ist, die CaNa₂SiO₄, CaNa₄Si₃O₉, Sr (NO₃)₂, MgONa₂O·SiO₂ und Ca (NO₃)₂ enthält.

9. Abbildungssystem nach einem der vorhergehenden Ansprüche, **dadurch gekennzeichnet, dass** das optische Element (100) eine bildseitig letzte brechende Linse des Abbildungssystems ist.

10. Abbildungssystem nach einem der vorhergehenden Ansprüche, **dadurch gekennzeichnet, dass** das optische Element (100) eine plane Lichtaustrittsfläche aufweist.

11. Abbildungssystem nach einem der vorhergehenden Ansprüche, **dadurch gekennzeichnet, dass** das optische Element (100) eine objektebenenseitig konvex gekrümmte Lichteintrittsfläche aufweist.

12. Abbildungssystem nach einem der vorhergehenden Ansprüche, **dadurch gekennzeichnet, dass** das optische Element (100) aus einem ersten Teilelement (10) mit Brechkraft und einem zweiten, im Wesentlichen brechkraftlosen Teilelement (20) zusammengesetzt ist.

13. Abbildungssystem nach Anspruch 12, **dadurch gekennzeichnet, dass** das erste Teilelement (10) eine im Wesentlichen plankonvexe Linse ist.

14. Abbildungssystem nach Anspruch 12 oder 13, **dadurch gekennzeichnet, dass** der zweite Teilelement (20) eine planparallele Platte ist.

15. Abbildungssystem nach einem der Ansprüche 12 bis 14, **dadurch gekennzeichnet, dass** das kubische Kristallmaterial im dem ersten Teilelement (10) vorgesehen ist, wobei in dem zweiten, im Wesentlichen brechkraftlosen Teilelement (20) ein zweites Material mit größerer Brechzahl als das Material in dem ersten Teilelement (10) vorgesehen ist.

16. Abbildungssystem nach Anspruch 15, **dadurch gekennzeichnet, dass** das zweite Material aus der Gruppe ausgewählt ist, die Magnesiumspinell (MgAl₂O₄), Yttriumaluminiumgranat (Y₃Al₅O₁₂), Magnesiumoxid (MgO) und Scandiumaluminiumgranat (Sc₃Al₅O₁₂) enthält.

17. Abbildungssystem nach einem der Ansprüche 12 bis 16, **dadurch gekennzeichnet, dass** das zweite Teilelement (20) eine Elementachse und wenigstens zwei Teilbereiche (21, 22) aufweist, welche den gleichen Kristallschnitt aufweisen und gegeneinander um die Elementachse verdreht angeordnet sind.

18. Abbildungssystem nach Anspruch 17, **dadurch gekennzeichnet, dass** der erste Teilbereich (21) und der zweite Teilbereich (22) jeweils einen (111)-Kristallschnitt aufweisen und gegeneinander um 60°+k*120° (k=0, 1, 2,..:) um die Elementachse verdreht angeordnet sind.

19. Abbildungssystem nach Anspruch 17, **dadurch gekennzeichnet, dass** der erste Teilbereich und der zweite Teilbereich jeweils einen (100)-Kristallschnitt aufweisen und gegeneinander um 45°+1*90° (1=0, 1, 2,...) um die Elementachse verdreht angeordnet sind.

20. Abbildungssystem nach einem der Ansprüche 12 bis 19, **dadurch gekennzeichnet, dass** das zweite Teilelement eine Elementachse und wenigstens vier Teilbereiche (21-24) aufweist, wobei ein erster Teilbereich (21) und ein zweiter Teilbereich (22) jeweils einen (111)-Kristallschnitt aufweisen und gegeneinander um 60°+k*120° (k=0,1,2,...) um die Elementachse verdreht angeordnet sind, und wobei ein dritter Teilbereich (23) und ein vierter Teilbereich (24) jeweils einen (100)-Kristallschnitt aufweisen und gegeneinander um 45°+1*90° (1=0,1,2,...) um die Elementachse verdreht angeordnet sind.

21. Abbildungssystem nach einem der vorhergehenden Ansprüche, **dadurch gekennzeichnet, dass** die Arbeitswellenlänge weniger als 250 nm, bevorzugt weniger als 200 nm beträgt.

22. Mikrolithographische Projektionsbelichtungsanlage mit einem Projektionsobjektiv, welches ein Abbildungssystem nach einem der vorhergehenden Ansprüche ist.

23. Verfahren zur mikrolithographischen Herstellung mikrostrukturierter Bauelemente mit folgenden Schritten:
• Bereitstellen eines Substrats (206), auf das zumindest teilweise eine Schicht aus einem lichtempfindlichen Material aufgebracht ist;
• Bereitstellen einer Maske (204), die abzubildende Strukturen aufweist;
• Bereitstellen einer Projektionsbelichtungsanlage (200) nach Anspruch 22;
• Projizieren wenigstens eines Teils der Maske (204) auf einen Bereich der Schicht mit Hilfe der Projektionsbelichtungsanlage (200).

## Claims

1. Imaging system, in particular a projection lens of a microlithographic projection exposure apparatus, with
• at least one optical element (100) which comprises a cubic-crystalline material having a refractive index n that is larger than 1.6 at a given operating wavelength;
• and an image-side numerical aperture NA that is smaller than the refractive index n;
• wherein the difference (n-NA) between the refractive index n and the numerical aperture NA of the imaging system is at most 0.2.

2. Imaging system, in particular a projection lens of a microlithographic projection exposure apparatus, with
• at least one optical element (100) which comprises a cubic-crystalline material having a refractive index n at a given operating wavelength;
• and an image-side numerical aperture NA, that is smaller than the refractive index n, of at least 1.50;
• wherein the difference (n-NA) between the refractive index n and the numerical aperture NA of the imaging system is at most 0.2.

3. Imaging system according to claim 1 or 2, **characterized in that** the difference (n-NA) between the refractive index n and the numerical aperture NA lies in the range from 0.05 to 0.20.

4. Imaging system according to one of the preceding claims, **characterized in that** the cubic-crystalline material comprises an oxide.

5. Imaging system according to claim 4, **characterized in that** the cubic-crystalline material comprises sapphire (Al₂O₃) and a potassium- or calcium oxide.

6. Imaging system according to one of the preceding claims, **characterized in that** the cubic-crystalline material comprises at least one material selected from the group that contains 7Al₂O₃·12CaO, Al₂O_{3·}K₂O, Al₂O₃·3CaO, Al₂O₃·SiO₂KO, Al₂O₃·SiO₂·2K and Al₂O₃·3CaO6H₂O.

7. Imaging system according to one of the preceding claims, **characterized in that** the cubic-crystalline material comprises calcium, sodium and silicon oxide.

8. Imaging system according to one of the preceding claims, **characterized in that** the cubic-crystalline material comprises at least one material selected from the group that contains CaNa₂SiO₄, CaNa₄Si₃O₉, Sr(NO₃)₂, MgONa₂O·SiO₂ und Ca (NO₃)₂.

9. Imaging system according to one of the preceding claims, **characterized in that** the optical element (100) is a lens with refractive power located in last position to the image side of the imaging system.

10. Imaging system according to one of the preceding claims, **characterized in that** the optical element (100) has a planar light-exit surface.

11. Imaging system according to one of the preceding claims, **characterized in that** the optical element (100) has a light-entrance surface that is convex-curved at the object-side.

12. Imaging system according to one of the preceding claims, **characterized in that** the optical element (100) is composed of a first partial element (10) having refractive power and a second partial element (20) having substantially no refractive power.

13. Imaging system according to claim 12, **characterized in that** the first partial element (10) is a substantially planar-convex lens.

14. Imaging system according to claim 12 or 13, **characterized in that** the second partial element (20) is a planar-parallel plate.

15. Imaging system according to one of the claims 12 to 14, **characterized in that** the cubic-crystalline material is present in the first partial element (10), while the second partial element (20) which is substantially without refractive power comprises a second material with a larger refractive index than the material in the first partial element (10).

16. Imaging system according to claim 15, **characterized in that** the second material is selected from the group that contains magnesium spinel (MgAl₂O₄), yttrium aluminum garnet (Y₃Al₅O₁₂), magnesium oxide (MgO) und scandium aluminum garnet (Sc₃Al₅O₁₂).

17. Imaging system according to one of the claims 12 to 16, **characterized in that** the second partial element (20) has an element axis and at least two portions (21, 22) that are of the same crystallographic cut and are arranged rotated relative to each other about the element axis.

18. Imaging system according to claim 17, **characterized in that** the first portion (21) and the second portion (22) are each of a crystallographic (111)-cut and are arranged rotated relative to each other by 60°+ k*120° (k = 0, 1, 2, ...) about the element axis.

19. Imaging system according to claim 17, **characterized in that** the first portion and the second portion are each of a crystallographic (100)-cut and are arranged rotated relative to each other by 45°+ 1*90° (1 = 0, 1, 2, ...) about the element axis.

20. Imaging system according to one of the claims 12 to 19, **characterized in that** the second partial element has an element axis and at least four portions (21-24), wherein a first portion (21) and a second portion (22) are each of a crystallographic (111)-cut and are arranged with their orientations rotated relative to each other by 60°+ k*120^{o} (k = 0, 1, 2, ...) about the element axis, and wherein a third portion (23) and a fourth portion (24) are each of a crystallographic (100)-cut and are arranged rotated relative to each other by 45°+ 1*90° (1 = 0, 1, 2, ...) about the element axis.

21. Imaging system according to one of the preceding claims, **characterized in that** the operating wavelength is shorter than 250 nm, preferably shorter than 200 nm.

22. Microlithographic projection exposure apparatus with a projection lens that is an imaging system according to one of the preceding claims.

23. Method for the microlithographic manufacture of micro-structured components, with the following steps:
• providing a substrate (206) on at least part of which a coating of a light-sensitive material is deposited;
• providing a mask (204) which carries structures of which an image is to be formed;
• providing a projection exposure apparatus (200) according to claim 22;
• projecting at least a part of the mask (204) onto an area of the coating by means of the projection exposure apparatus (200).

## Revendications

1. Système de reproduction, en particulier objectif de projection d'une installation d'exposition par projection microlithographique, comportant
• au moins un élément optique (100), lequel présente un matériau cristallin cubique qui possède un indice de réfraction n supérieur à 1,6 pour une longueur d'onde de travail prédéfinie ;
• et une ouverture numérique NA côté image qui est inférieure à l'indice de réfraction n ;
• la différence (n-NA) entre l'indice de réfraction n et l'ouverture numérique NA du système de reproduction étant au maximum égale à 0,2.

2. Système de reproduction, en particulier objectif de projection d'une installation d'exposition par projection microlithographique, comportant
• au moins un élément optique (100), lequel présente un matériau cristallin cubique qui possède un indice de réfraction n pour une longueur d'onde de travail prédéfinie ;
• et une ouverture numérique NA côté image qui est inférieure à l'indice de réfraction n et au moins égale à 1,50 ;
• la différence (n-NA) entre l'indice de réfraction n et l'ouverture numérique NA du système de reproduction étant au maximum égale à 0,2.

3. Système de reproduction selon la revendication 1 ou 2, **caractérisé en ce que** la différence (n-NA) entre l'indice de réfraction n et l'ouverture numérique NA se situe dans la plage allant de 0,05 à 0,20.

4. Système de reproduction selon une des revendications précédentes, **caractérisé en ce que** le matériau cristallin cubique présente un oxyde.

5. Système de reproduction selon la revendication 4, **caractérisé en ce que** le matériau cristallin cubique présente du saphir (Al₂O₃) et un oxyde de potassium ou de calcium.

6. Système de reproduction selon une des revendications précédentes, **caractérisé en ce que** le matériau cristallin cubique présente au moins un matériau sélectionné parmi le groupe qui contient 7Al₂O₃·12CaO, Al₂O₃·K₂O, Al₂O₃·3CaO, Al₂O₃·SiO₂KO, Al₂O₃·SiO₂·2K et Al₂O₃·3CaO6H₂O.

7. Système de reproduction selon une des revendications précédentes, **caractérisé en ce que** le matériau cristallin cubique présente du calcium, du sodium et de l'oxyde de silicium.

8. Système de reproduction selon une des revendications précédentes, **caractérisé en ce que** le matériau cristallin cubique présente au moins un matériau sélectionné parmi le groupe qui contient CaNa₂SiO₄, CaNa₄Si₃O₉, Sr(NO₃)₂, MgONa₂O·SiO₂ et Ca(NO₃)₂.

9. Système de reproduction selon une des revendications précédentes, **caractérisé en ce que** l'élément optique (100) est une lentille réfringente placée en dernier du côté image du système de reproduction.

10. Système de reproduction selon une des revendications précédentes, **caractérisé en ce que** l'élément optique (100) présente une surface de sortie de lumière plane.

11. Système de reproduction selon une des revendications précédentes, **caractérisé en ce que** l'élément optique (100) présente une surface d'entrée de lumière convexe du côté du plan objet.

12. Système de reproduction selon une des revendications précédentes, **caractérisé en ce que** l'élément optique (100) est composé d'un premier élément partiel (10) avec pouvoir réfringent et d'un deuxième élément partiel (20) essentiellement sans pouvoir réfringent.

13. Système de reproduction selon la revendication 12, **caractérisé en ce que** le premier élément partiel (10) est une lentille essentiellement plan-convexe.

14. Système de reproduction selon la revendication 12 ou 13, **caractérisé en ce que** le deuxième élément partiel (20) est une plaque à faces planes et parallèles.

15. Système de reproduction selon une des revendications 12 à 14, **caractérisé en ce que** le matériau cristallin cubique est prévu dans le premier élément partiel (10), un deuxième matériau d'indice de réfraction plus grand que le matériau dans le premier élément partiel (10) étant prévu dans le deuxième élément partiel (20) essentiellement sans pouvoir réfringent.

16. Système de reproduction selon la revendication 15, **caractérisé en ce que** le deuxième matériau est sélectionné parmi le groupe qui contient spinelle de magnésium (MgAl₂O₄), grenat d'yttrium-aluminium (Y₃Al₅O₁₂), oxyde de magnésium (MgO) et grenat de scandium-aluminium (SC₃Al₅O₁₂).

17. Système de reproduction selon une des revendications 12 à 16, **caractérisé en ce que** le deuxième élément partiel (20) présente un axe d'élément et au moins deux parties (21, 22) qui présentent la même coupe cristallographique et sont tournées l'une par rapport à l'autre autour de l'axe d'élément.

18. Système de reproduction selon la revendication 17, **caractérisé en ce que** la première partie (21) et la deuxième partie (22) présentent chacune une coupe cristallographique (111) et sont tournées l'une par rapport à l'autre de 60° +k*120° (k=0, 1, 2, ...) autour de l'axe d'élément.

19. Système de reproduction selon la revendication 17, **caractérisé en ce que** la première partie et la deuxième partie présentent chacune une coupe cristallographique (100) et sont tournées l'une par rapport à l'autre de 45°+1*90° (1=0, 1, 2, ...) autour de l'axe d'élément,

20. Système de reproduction selon une des revendications *12 à 19, **caractérisé en ce que** le deuxième élément partiel présente un axe d'élément et au moins quatre parties (21 - 24), une première partie (21) et une deuxième partie (22) présentant chacune une coupe cristallographique (111) et étant tournées l'une par rapport à l'autre de 60°+k*120° (k=0, 1, 2,...) autour de l'axe d'élément, et une troisième partie (23) et une quatrième partie (24) présentant chacune une coupe cristallographique (100) et étant tournées l'une par rapport à l'autre de 45°*1*90° (1=0, 1, 2,...) autour de l'axe d'élément.

21. Système de reproduction selon une des revendications précédentes, **caractérisé en ce que** la longueur d'onde de travail est inférieure à 250 nm, de préférence inférieure à 200 nm.

22. Installation d'exposition par projection microlithographique avec un objectif de projection qui est un système de reproduction selon une des revendications précédentes.

23. Procédé de fabrication microlithographique de composant microstructurés, comportant les étapes suivantes :
• préparation d'un substrat (206) sur lequel une couche en matériau photosensible est appliquée au moins partiellement ;
• préparation d'un masque (204) qui présente des structures à reproduire ;
• préparation d'une installation d'exposition par projection (200) selon la revendication 22 ;
• projection d'au moins une partie du masque (204) sur une région de la couche à l'aide de l'installation d'exposition par projection (200).
